# EUROPEAN PATENT SPECIFICATION

(11) **EP 0 298 782 B1**
(45) Date of publication and mention of the grant of the patent: **08.03.1995**
(21) Application number: 88306300.0
(22) Date of filing: 11.07.1988
(51) Int. Cl.: G03F 7/00

(54) **A photosensitive sheet and a method for the formation of images using the same**
Lichtempfindliche Schicht und Bildaufzeichnungsverfahren damit
Feuille photosensible et méthode pour l'obtention d'images avec cette feuille

(30) Priority: 10.07.1987 JP 173706/87; 25.08.1987 JP 210888/87
(43) Date of publication of application: 11.01.1989
(73) Proprietor: SHARP KABUSHIKI KAISHA, Osaka 545 (JP)
(72) Inventor: Tsujimoto, Yoshiharu, Yamatokohriyama-shi Nara-ken (JP); Ohashi, Kunio, Nara-shi Nara-ken (JP); Fujiwara, Yoshikazu, Shiki-gun Nara-ken (JP); Sasaki, Hiromu, Yamatokohriyama-shi Nara-ken (JP); Nagata, Syoichi, Yamatokohriyama-shi Nara-ken (JP)
(74) Representative: Kosmin, Gerald Emmanuel

(56) References cited:
- EP-A- 0 257 574
- EP-A- 0 298 781
- GB-A- 2 113 860
- US-A- 3 701 663
- US-A- 4 639 127
- IBM TECHNICAL DISCLOSURE BULLETIN, vol. 24, no. 6, November 1981, page 2679, New York, US ; R.F. ANTONUCCI et al. : "Use of reflective surface in exposing positive resist on printed circuit boards"

## Description

This invention relates to a photosensitive sheet that comprises a light-reflective substrate in the shape of a sheet coated with pressure-rupturable capsules containing a chromogenic material and a photosensitive material, and to a method for the formation of images using the said photosensitive sheet.

Japanese Laid-Open Patent Applications 58-88739 and 59-149343 disclose methods for the formation of images that make use of photosensitive sheets, which are composed of a light-permeable substrate in the shape of a sheet and pressure-rupturable capsules coated on the substrate. The capsules contain a specific chromogenic material and a photosensitive material.

When this kind of photosensitive sheet is exposed to light from or through a certain image, only the pressure-rupturable capsules that were exposed on the top of the photosensitive sheet harden, resulting in a latent image on the photosensitive sheet that corresponds to the image from or through which the sheet was exposed to light. When the photosensitive sheet on which a latent image is formed is brought together with an image-receiving sheet that is coated with developing materials that give rise to colors with the chromogenic material inside the pressure-rupturable capsules, the pressure-rupturable capsules that are still not hardened rupture, and the chromogenic material contained in these pressure-rupturable capsules flows out. Then there is a reaction between the chromogenic material and the developing materials of the image-receiving sheet, which gives rise to color in the said chromogenic material, which forms an image on the image-receiving sheet.

It is also possible to form colored images by the use of the above-mentioned photosensitive sheet. For example, three kinds of photosensitive materials hardened by light are used that are hardened by wavelengths in the red, green, or blue regions, and one of the three kinds of photosensitive materials and a chromogenic material that gives rise to a color complementary to that color of light are contained in the same pressure-rupturable capsules. In this way, three kinds of pressure-rupturable capsules are prepared. That is, a material that is hardened by light with wavelengths in the blue region of light and a chromogenic material that gives rise to yellow, the color complementary to blue, are contained in some pressure-rupturable capsules (called Y capsules below); a material that is hardened by light with wavelengths in the green region of light and a chromogenic material that gives rise to magenta, the color complementary to green (called M capsules below); and a material that is hardened by light with wavelengths in the red region of light and a chromogenic material that gives rise to cyan, the color complementary to red (called C capsules below) are the three kinds of pressure-rupturable capsules prepared. Then, these three kinds of pressure-rupturable capsules are distributed evenly over the top of the light-permeable substrate in the shape of a sheet to give a coated photosensitive sheet. This photosensitive sheet, when it is exposed to light reflected from a manuscript that is illuminated with white light, has the photosensitive material in each of the pressure-rupturable capsules of the said photosensitive sheet harden in response to the amount of light of the various wavelengths of the light for exposure, resulting in the formation on the photosensitive sheet of a latent image that has color information. Then, the photosensitive sheet that has this kind of a latent image is put together with pressure with an image-receiving sheet coated with developing materials that give rise to specific colors when they react with the chromogenic materials in the different pressure-rupturable capsules. In this way, the pressure-rupturable capsules on the said photosensitive sheet that have photosensitive material that is still not hardened are ruptured, and the chromogenic material in the inside flows out, reacting with the developing materials of the image-receiving material, giving rise to a specific color. The result is that a color image is formed on the image-receiving sheet that corresponds to the color image of the manuscript.

In this way, in the method for the formation of color images by use of a photosensitive sheet coated evenly with three kinds of pressure-rupturable capsules on top of a light-permeable substrate, it is not necessary to decompose the color images of the manuscript into the wavelengths of the light (blue, green, and red) to which the photosensitive materials of the different pressure-rupturable capsules are sensitive. Therefore, this method for the formation of images can be used to form a latent image that corresponds to the color image of the manuscript on the photosensitive sheet with exposure to light that is merely white light reflected from the manuscript.

However, the photosensitive material contained in the pressure-rupturable capsules of the photosensitive sheet is relatively insensitive to light, and for that reason, by simple exposure of the photosensitive sheet to the image of the manuscript, there is a possibility that the specific photosensitive material will not harden. Moreover, if the amount of light used for exposure is small, there is a possibility that the time taken for hardening of the photosensitive material will be long. In order to decrease these possibilities, the increasing of the amount of light used to expose the photosensitive sheet has been tried. However, to do this, it is necessary to increase the scale of the light source, to lengthen the time of exposure, and so on. Also, if the amount of light used for exposure of the photosensitive sheet is increased, photosensitive material that should not be hardened may become hardened.

The photosensitive materials that are contained in the pressure-rupturable capsules that coat the photosensitive sheet have individual light-sensitivities depending on their variety. For this reason, it is extremely difficult to have equal sensitivity to the different wavelengths of light when the three kinds of photosensitive materials are hardened by three different wavelengths of light. Therefore, the pressure-rupturable capsules that contain photosensitive materials with poor light-sensitivity are hardened with difficulty, and when these pressure-rupturable capsules are ruptured when the photosensitive sheet and the image-receiving sheet are placed together with pressure, there is the danger that the chromogenic material on their insides will give rise to color. In this case, it will not be possible to reproduce the color image of the manuscript faithfully.

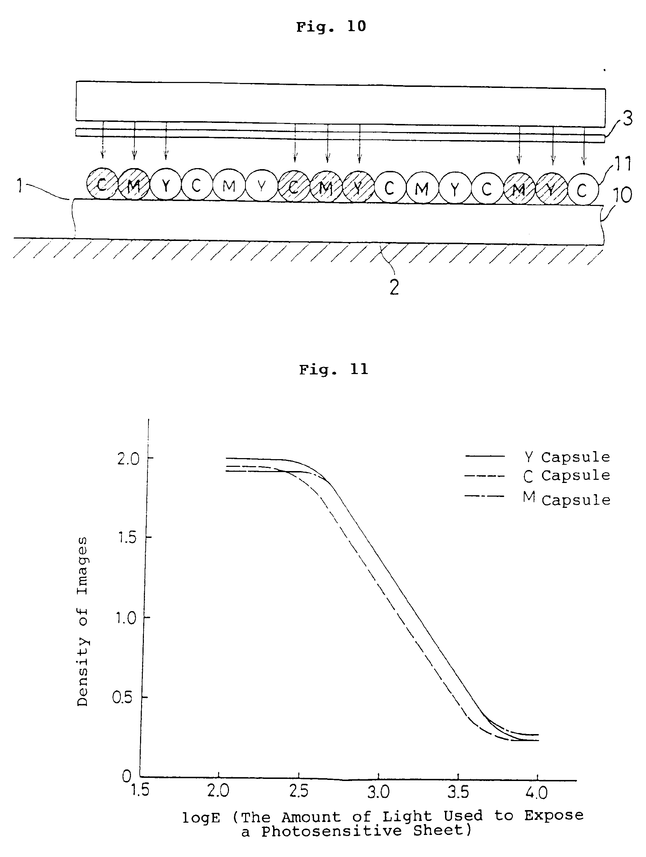

In order to solve these kinds of problems, a method for the exposure of photosensitive sheets has been proposed in which white light is used to illuminate the manuscript, and the amount of light that reflects from the said manuscript is calibrated by filters. As shown in Figure **10**, the photosensitive sheet **10** that is used in this method is constituted of a light-permeable substrate **11** made of polyester film or the like and three kinds of pressure-rupturable capsules **12** that give rise to three different colors. The pressure-rupturable capsules **12** include **C** capsules that contain a chromogenic material that gives rise to the color cyan at the time of development, **M** capsules that contain a chromogenic material that gives rise to the color magenta at the time of development, and **Y** capsules that contain a chromogenic material that gives rise to the color yellow at the time of development. The different kinds of capsules are evenly distributed so as to coat the top of the substrate **11**. This photosensitive sheet **10** is placed on the top of a sheet-exposure stand, and a manuscript **6** is illuminated with white light, so that the light that is reflected from the said manuscript **6** passes through a filter **3**, exposing the sheet and selectively hardening the different pressure-rupturable capsules **12** (the pressure-rupturable capsules that are hatched in the figure are hardened). This forms a latent image with color information on the photosensitive sheet **10**. The filter **3** functions to calibrate the sensitivity of the three kinds of pressure-rupturable capsules. Each kind of pressure-rupturable capsule has its own sensitivity characteristics, as shown, for example, in Figure **11**, wherein the sensitivity of the **C** capsules is greater than the sensitivities of the **Y** capsules and the **M** capsules. Therefore, even if the amount of red light to which the **C** capsules are sensitive is small, the said **C** capsules will harden. For that reason, in order to make the sensitivity of the three kinds of pressure-rupturable capsules the same, a filter that absorbs the red light to which the **C** capsules are sensitive is used, and the amount of said red light is decreased, which is the same in effect as increasing the amount of light in the wavelengths to which the **Y** capsules and the **M** capsules are sensitive. In this way, the apparent shift of the characteristic curve of the **C** capsules shown in Figure **11** to the right can be attained. By this principle, if proper absorbance characteristics of red light by the filter **3** are selected, then, as shown in Figure **9**, it is possible to make the sensitivity characteristics of each of the kinds of pressure-rupturable capsules apparently approximately equal.

However, in this method for the formation of an image in which the sensitivity of the pressure-rupturable capsules are calibrated by the use of the above-mentioned filter, because light is absorbed by the filter, the overall amount of light that is used for the exposure to light of the photosensitive sheet is decreased. For this reason, it is necessary to increase the overall amount of white light used to illuminate the manuscript, and thus, it is necessary both to increase the size of the light source and to lengthen the time of exposure.

US-A-3,701,663 discloses a photosensitive sheet similar to that shown in Figure 10 and according to the preamble of attached claim 1, wherein the sheet-shaped substrate is adapted to reflect light. A similar photosensitive sheet for which a reflector is provided, spaced from a substrate itself, is disclosed in US-A-4,639,127.

A photosensitive sheet according to the present invention, which overcomes the above-discussed and other disadvantages and deficiencies of the prior art, is for recording a color image and comprises a sheet-shaped substrate adapted to reflect light, a coating on said sheet-shaped substrate comprising three kinds of pressure-rupturable capsules each respective kind of which contains one kind of colorless chromogenic material and one kind of photosensitive material adapted to harden when exposed to light passing directly through said pressure-rupturable capsules or light reflected from said sheet-shaped substrate through said pressure-rupturable capsules, in the three kinds of pressure-rupturable capsules the three respective kinds of photosensitive material being sensitive to red, green and blue light respectively,
characterised in that said sheet-shaped substrate is adapted to reflect light in such manner that at least one component of red, green and blue components of light incident on the photosensitive sheet is absorbed, whilst the or each remaining component is reflected, in such manner as to compensate the sensitivities of the three kinds of photosensitive materials to substantially the same extent.

A light-reflective substance either coated on the sheet-shaped substrate or from which the sheet-substrate is made, has specific spectral reflectivity properties that correspond to the wavelengths of light to which any one of the photosensitive materials is photosensitive.

In a preferred embodiment, each of the chromogenic materials contained in said pressure-rupturable capsules gives rise to a color that is a complementary color to the color of the light of the wavelength to which said photosensitive materials contained in said pressure-rupturable capsules are photosensitive.

The method for the formation of images of this invention comprises placing the above-mentioned photosensitive sheet on a sheet-exposure stand; exposing said photosensitive sheet to light from or through a given image of a manuscript; placing said photosensitive sheet on an image-receiving sheet that is coated with developing materials so that said pressure-rupturable capsules of said photosensitive sheet can be brought into contact with said developing materials of said image-receiving sheet; and applying pressure to said two sheets. The light-reflective substance has specific spectral reflectivity properties that correspond to the wavelengths of light to which any one of the photosensitive materials is photosensitive.

Thus, the invention described herein makes possible the objectives of (1) providing a photosensitive sheet from which pressure-rupturable capsules of the photosensitive sheet are exposed to light reflected so that the hardening of the pressure-rupturable capsules can be effectively attained; (2) providing a method for the formation of images by which pressure-rupturable capsules of a photosensitive sheet are exposed to light reflected from the light-reflective substrate of a photosensitive sheet, there is no need to increase the size of the light source or to lengthen the exposure time; and (3) providing a method for the formation of images in which because there is no need for the use of a filter, a decrease in the amount of light needed for exposure can be prevented, resulting in a distinct color image with reproducibility.

For a better understanding of the invention and to show how the same may be carried into effect, reference will now be made, by way of example, to the accompanying drawings in which:
Figure **1** is a sectional view showing a photosensitive sheet not of this invention but shown for explanation;
Figure **2** is a sectional view showing another photosensitive sheet not of this invention but shown for explanation;
Figure **3** is a sectional view showing another photosensitive sheet not of this invention but shown for explanation;
Figure **4** is a graph showing the relationship between the image density and the energy of incidence with respect to a photosensitive sheet according to Figure 2 or 3 and a conventional photosensitive sheet;
Figure **5** is a diagram showing the exposure of a photosensitive sheet of this invention;
Figure **6** is a graph showing the apparent photosensitivity characteristics of the pressure-rupturable capsules of the photosensitive sheet shown in Figure **5**;
Figure **7** is a graph showing the light-permeability characteristics of the substrate of the photosensitive sheet of Figure **5**;
Figure **8** is a diagram showing the process by which a latent image on the photosensitive sheet of Figure **5** becomes visible;
Figure **9** is a graph showing the apparent sensitivity characteristics of the pressure-rupturable capsules used in a conventional method for the formation of images by the use of a filter;
Figure **10** is a diagram showing a conventional method for the formation of images; and
Figure **11** is a graph showing the sensitivity of the pressure-rupturable capsules used in the conventional method for the formation of images.

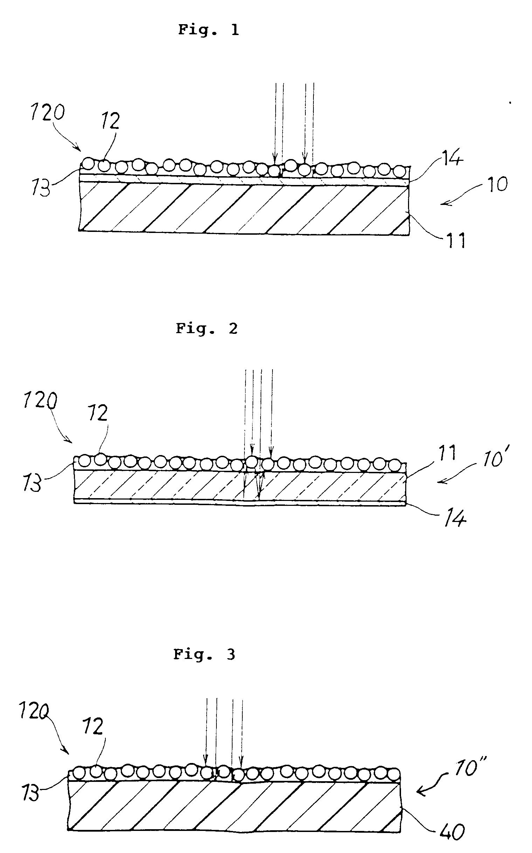

Figure **1** shows a photosensitive sheet which comprises a sheet-shaped substrate **11** with a thickness of about twelve micrometers to several dozens of micrometers (e.g., 25 »m) that is made of polyethylene terephthalate (PET), an aluminum layer **14** with a thickness of about 2 »m that is formed on the top surface of the substrate **11** by the well known vapor deposition method, and a microcapsule layer **120** that is formed by coating pressure-rupturable capsules **12** on the aluminum layer **14** by the use of a binder **13.**

In the pressure-rupturable capsules **12**, there are photosensitive materials (e.g., compounds having two or more ethylenically unsaturated terminal groups) that harden when illuminated by light, and chromogenic materials (e.g., colorless compounds having in its partial skeleton a lactone, a lactam, a sultone, a spiropyran, an ester, or an amino structure) that give rise to a specific color. The diameter of each of the capsules is about 5-6 »m.

When the photosensitive sheet **10** is illuminated with light that has reflected from a manuscript or light from laser devices, some of the light is directly absorbed by certain pressure-rupturable capsules **12**, hardening the photosensitive materials contained in their insides, as shown in Figure **1** by the arrows. The remaining light passes through the capsules **12** and the binder **13**, and reaches the surface of the aluminum layer **14** by which the light undergoes diffused reflection or mirror-wise reflection and returns to the capsules **12**, by which the light is absorbed, hardening the photosensitive materials contained in the capsules **12**. In this way, the photosensitive materials that must be hardened by light are hardened both by light reflected from the manuscript and by light reflected from the aluminum layer **14,** so the photosensitive materials are hardened without fail.

In this way, a latent image is formed on the photosensitive sheet **10** that corresponds to the image of the manuscript. Then, photosensitive sheet **10** on which this latent image has been formed is placed together with an image-receiving sheet and pressure is applied thereto. The image-receiving sheet is composed of a substrate in the shape of a sheet that is coated with developing materials. The developing materials are those conventionally employed in carbonless paper technology and are well known, examples of which are clay minerals such as acid clay, active clay; organic acid such as tannic acid; acid polymers such as phenol-formaldehyde resins, etc. The developing materials of the said image-receiving sheet and the pressure-rupturable capsules **12** of the photosensitive sheet **10** are placed together so as to come into contact with each other, and pressed together. Accordingly, the non-hardened pressure-rupturable capsules **12** of the photosensitive sheet **10** rupture, and the chromogenic material contained inside of these pressure-rupturable capsules flows out. The said chromogenic material reacts with the developing materials of the image-receiving sheet, giving rise to color, and forming a particular image on the image-receiving sheet. In this way, the latent image that is formed on the photosensitive sheet **10** is developed, becoming visible, when brought together with the image-receiving sheet, and the image is transcribed onto the image-receiving sheet. The substrate of the image-receiving sheet need not be permeable to light; paper, resin, or the like can be used.

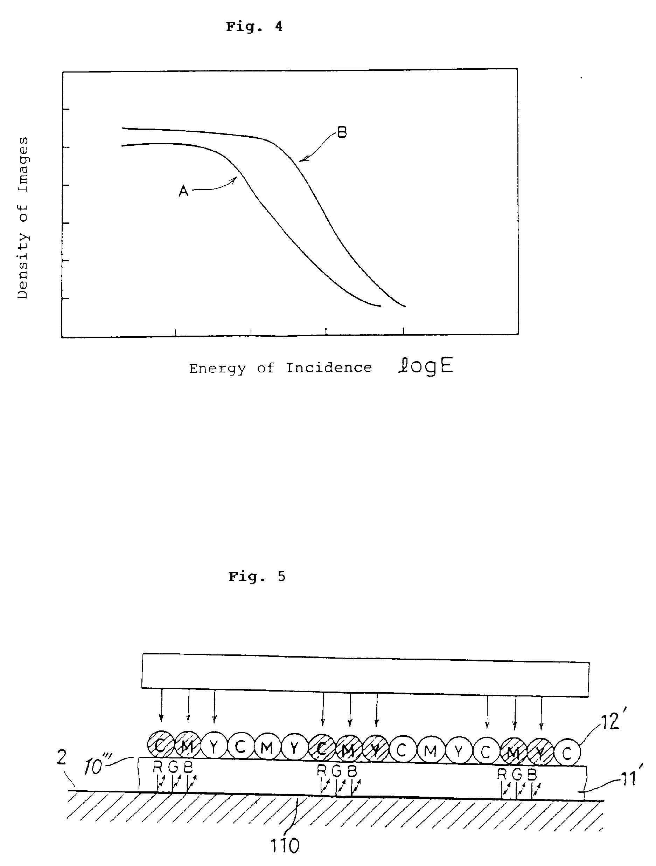

Figure **2** shows another photosensitive sheet, which comprises a sheet-shaped light-permeable substrate **11** with a thickness of 15 »m that is made of PET, an aluminum layer **14** with a thickness of about 1 »m that is formed on the bottom surface of the substrate **11**, and a microcapsule layer **120** that is formed by coating pressure-rupturable capsules **12** on the top surface of the substrate **11** by the use of a binder **13**.

When the photosensitive sheet **10′** is illuminated with light that has reflected from a manuscript or light from laser devices, some of the light is directly absorbed by certain pressure-rupturable capsules **12**, hardening the photosensitive materials contained in their insides, as shown in Figure **2** by the arrows. The remaining light passes through the capsules **12**, the binder **13**, and the substrate **11**, and reaches the surface of the aluminum layer **14** by which the light undergoes diffused reflection or mirror-wise reflection and returns to the capsules **12**, by which the light is absorbed, hardening the photosensitive materials contained in the capsules **12**. In this way, the photosensitive materials that must be hardened by light are hardened both by light reflected from the manuscript and by light reflected from the aluminum layer **14**, so the photosensitive materials are hardened without fail.

Although Figures 1 and 2 disclose an aluminum layer by which the substrate **11** becomes light-reflective, other metal vapor-deposition layers or white pigment-coated layers that are formed on the substrate can be employed.

Figure 3 shows another photosensitive sheet, which comprises a sheet-shaped substrate **40** with a thickness of 25 »m that is made of polyethylene film into which white pigment is dispersed, and a microcapsule layer **120** that is formed by coating pressure-rupturable capsules **12** on the top surface of the substrate **40** by the use of a binder **13**. The white-colored substrate **40** is light-reflective.

When the photosensitive sheet **10˝** is illuminated with light that has reflected from a manuscript or light from laser devices, some of the light is absorbed by certain pressure-rupturable capsules **12**, hardening the photosensitive materials contained in their insides, as shown in Figure **3** by the arrows. The remaining light passes through the capsules **12** and the binder **13**, and reaches the substrate **40** by which the light undergoes diffused reflection or mirror-wise reflection and returns to the capsules **12**, by which the light is absorbed, hardening the photosensitive materials contained in the capsules **12**. In this way, the photosensitive materials are hardened both by light reflected from the manuscript and by light reflected from the substrate **40**, so the photosensitive materials are hardened without fail.

As mentioned above, the light that has passed through the microcapsule layer **120** or the microcapsule layer **120** and the substrate **11** undergoes diffused reflection or mirror-wise reflection by the aluminum layer **14** of the substrate **11** or the substrate **40** itself and returns to the capsules **12**, by which the light is absorbed. Even when the light undergoes diffused reflection by the aluminum layer **14** or the substrate **40**, pressure-rupturable capsules **12** that need not be light-hardened will not be hardened, because the said microcapsule layer **120** and the substrate **11** are thin and the amount of light that permeates therethrough is slight. The photosensitive materials contained in the capsules **12** are hardened both by light reflected from the manuscript and by light reflected from the aluminum layer **14** or the substrate **40**, so that the hardening of the photosensitive materials can be accelerated.

Figure **4** compares the density of the images with the use of the photosensitive sheet of Figures 2 and 3, **A**, and the use of a conventional photosensitive sheet, **B**, when the length of the time of illumination is the same, wherein the abscissa indicates the relative value of the energy of incidence and the ordinate indicates the density of the image. It can be seen from Figure **4** that when the photosensitive sheet of Figure 2 or 3 is used, the pressure-rupturable capsules of the specific areas that have been exposed to light are hardened without fail, which makes it possible to reproduce the image with faithfulness, whereas when the conventional photosensitive sheet is used, the density of the image becomes high, which makes it impossible to reproduce the image of the manuscript faithfully.

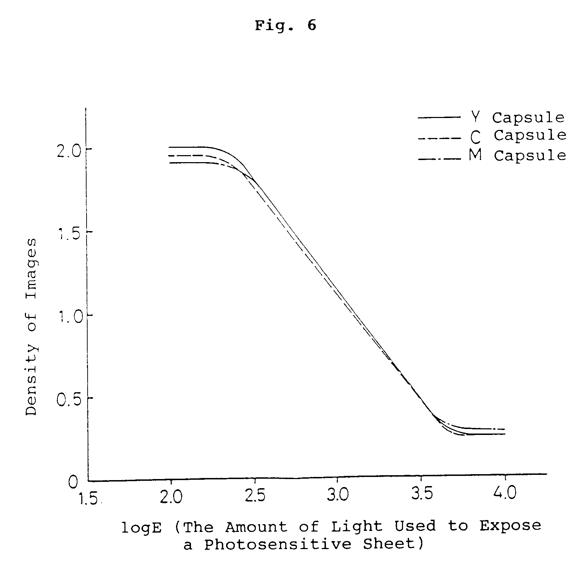

Figure **5** shows a method for the formation of colored images by the use of a photosensitive sheet. The photosensitive sheet **10‴** comprises a colorless, transparent substrate **11′** in the shape of a sheet, three kinds of pressure-rupturable capsules **12′** that are uniformly dispersed on the top surface of the substrate **11′**, and a resin layer **110** that is painted on the bottom surface of the substrate **11′**.

The substrate **11′** has a thickness of about twelve micrometers to several dozens of micrometers. The pressure-rupturable capsules **12′** that coat the said substrate **11′** include pressure-rupturable capsules **Y** that contain photosensitive materials that are hardened by light in the blue wavelength and a chromogenic material (a colorless pigment) that gives rise to yellow, which is the complementary color to blue; pressure-rupturable capsules **M** that contain photosensitive materials that are hardened by light in the green wavelength and a chromogenic material (a colorless pigment) that gives rise to magenta, which is the complementary color to green; and pressure-rupturable capsules **C** that contain photosensitive materials that are hardened by light in the red wavelength and a chromogenic material (a colorless pigment) that gives rise to cyan, which is the complementary color to red. The diameter of the individual pressure-rupturable capsules is 5-6 »m. The resin layer **110** (e.g., a PET layer) has specific spectral reflective properties that cause it to reflect all light except for red light, 90% of which is absorbed by the resin layer **110**. When the photosensitive sheet **10‴** is placed on a sheet-exposure stand **2** and white light is used to illuminate a manuscript (not shown), the light reflected from the manuscript illuminates the photosensitive sheet **10‴**, and most of the light that has been reflected from the manuscript to illuminate the photosensitive sheet **10‴** is absorbed by the pressure-rupturable capsules **12′** of the photosensitive sheet **10‴**, but some of the light passes through the light-permeable substrate **11′** of the photosensitive sheet **10‴**, to be reflected from the resin layer **110**, passing again through the substrate **11′** to reach the pressure-rupturable capsules **12′**. At this time, the resin layer **110** absorbs 90% of the red light of the total light that is incident upon the said resin layer **110**, and reflects all of the rest of the light. Accordingly, as shown in Figure **5**, the green light (**G**) and the blue light (**B**) that reaches the resin layer **110** of the substrate **11′** is not absorbed by the resin layer **110**, but all of this light reaches the pressure-rupturable capsules **12′**, and is absorbed by the **Y** capsules and the M capsules, respectively. In contrast, the red light (**R**) that reaches the resin layer **110** of the substrate **11′** is almost all absorbed by the resin layer **110**, and only some of the red light (**R**) is reflected by the resin layer **110**, to reach the pressure-rupturable capsules **12′**, and to be absorbed by the **C** capsules.

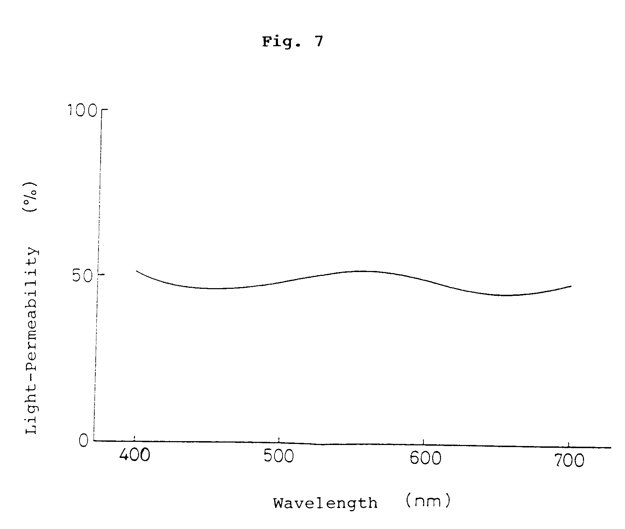

The pressure-rupturable capsules **12′** of the photosensitive sheet **10‴** have the sensitivity properties shown in Figure **11**, and when an image is formed by the use of a photosensitive sheet **10‴** coated with pressure-rupturable capsules **12′** with these kinds of sensitivity characteristics, as shown in Figure **6**, the apparent sensitivity of the pressure-rupturable capsules **12′** can be made to be almost the same as the apparent sensitivity of the pressure-rupturable capsules **12′** when the photosensitive sheet is exposed to light with use of a conventional filter (see Figure **9**). Besides, in this case, compared to the situation in which a filter is used, the light that reaches the photosensitive sheet **10‴** is almost 1.3 times as great. The spectral permeation characteristics of the light-permeable substrate **11′** of the photosensitive sheet **10‴** at this time are shown in Figure **7**. In this example, the resin layer **110** is made of a specific resin with spectral reflective properties such that 90% of red light is absorbed; this property changes with changes in the spectral permeation characteristics of the light-permeable substrate **11′** of the photosensitive sheet **10‴** (see Figure **7**) and the like, so it is preferable to find the optimum value by experiment.

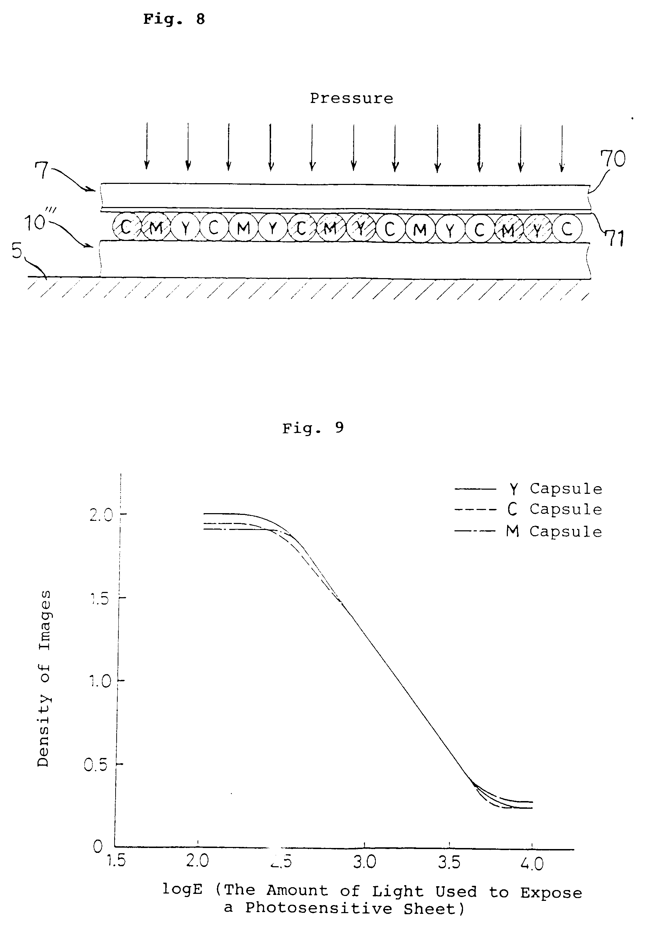

In this way, the photosensitive sheet **10‴** that has a latent image thereon with specific color information is brought together with an image-receiving sheet **7**, as shown in Figure **8**, and the two are pressed together. The image-receiving sheet **7** is made of a substrate **70** in the form of a sheet that is coated with developing materials **71** that give rise to color when brought into contact with the chromogenic material of the pressure-rupturable capsules. The image-receiving sheet **7** is disposed on the photosensitive sheet **10‴** in such a way that the developing materials **71** of the image-receiving sheet **7** and the pressure-rupturable capsules **12′** of the photosensitive sheet **10‴** are brought into contact, and then pressure is applied to the two, rupturing the pressure-rupturable capsules **12′** that have not hardened, causing the chromogenic materials inside to flow out. This chromogenic material reacts with the developing materials **71**, and each chromogenic material gives rise to a specific color, so that a colored image is formed on the image-receiving sheet **7** that corresponds to the colored image of the manuscript.

As described above, it is possible to calibrate the light-sensitivity of the pressure-rupturable capsules without the use of a filter, and compared to when a filter is used to adjust the amount of light used to expose the photosensitive sheet **10‴**, there is 1.3 times as much light, so there is no need to increase the size of the light source, or to increase the intensity of the light source by increasing the amount of electricity supplied. Moreover, when slit exposure is used, it is not necessary to increase the length of the exposure. The light that has once passed through the substrate of the photosensitive sheet is once more reflected by the resin layer of the photosensitive sheet, and can once more be used for exposure, so there is the merit of the efficient use of the light.

Although, in order to have the substrate have specific spectral reflective properties, the bottom surface of the substrate is coated with resin that has specific spectral reflective properties, the resin can be incorporated into the substrate, resulting in a substrate with specific spectral reflective properties.

## Claims

1. A photosensitive sheet for recording a color image, comprising a sheet-shaped substrate adapted to reflect light, a coating on said sheet-shaped substrate comprising three kinds of pressure-rupturable capsules each respective kind of which contains one kind of colorless chromogenic material and one kind of photosensitive material adapted to harden when exposed to light passing directly through said pressure-rupturable capsules or light reflected from said sheet-shaped substrate through said pressure-rupturable capsules, in the three kinds of pressure-rupturable capsules the three respective kinds of photosensitive material being sensitive to red, green and blue light respectively,
characterised in that said sheet-shaped substrate is adapted to reflect light in such manner that at least one component of red, green and blue components of light incident on the photosensitive sheet is absorbed, whilst the or each remaining component is reflected, in such manner as to compensate the sensitivities of the three kinds of photosensitive materials to substantially the same extent.

2. A photosensitive sheet according to claim 1, wherein the sheet-shaped substrate is adapted to reflect light by having at least one light-reflective surface.

3. A photosensitive sheet according to claim 2, wherein said at least one light-reflective surface is provided by a coating of a light-reflective substance.

4. A photosensitive sheet according to claim 1, wherein the sheet-shaped substrate is adapted to reflect light by being made of a light-reflective substance.

5. A photosensitive sheet according to any preceding claim, wherein the sheet-shaped substrate is adapted to reflect light in such manner that red component of incident light is absorbed, whilst green and blue components thereof are reflected.

6. A photosensitive sheet according to any preceding claim, wherein said chromogenic substance contained in each pressure-rupturable capsule give rise to a color that is a complementary color of the light to which the photosensitive material contained in the capsule is sensitive.

7. A method for the formation of images comprising placing the photosensitive sheet of any one of the preceding claims on a sheet-exposure stand; exposing said photosensitive sheet to light from or through a given image of a manuscript; placing said photosensitive sheet on an image-receiving sheet that is coated with developing materials so that said pressure-rupturable capsules of said photosensitive sheet can be brought into contact with said developing materials of said image-receiving sheet; and applying pressure to said two sheets.

## Patentansprüche

1. Eine lichtempfindliche Schicht zum Aufzeichnen eines farbigen Bildes, welche ein schichtförmiges Substrat zum Reflektieren von Licht umfaßt, wobei eine Beschichtung auf dem schichtförmigen Substrat drei Sorten von Druckreißkapseln aufweist, wovon jede Sorte jeweils ein bestimmtes farbloses chromogenes Material enthält und ein bestimmtes lichtempfindliches Material, das bei direkt durch die Druckreißkapseln dringendem Licht oder vom schichtförmigen Substrat reflektiertem, durch die Druckreißkapseln dringendem Licht härtet, wobei die drei jeweiligen Arten lichtempfindlichen Materials in den drei Sorten Druckreißkapseln jeweils für rotes, grünes und blaues Licht empfindlich sind, **gekennzeichnet dadurch,** daß das schichtförmige Substrat so ausgelegt ist, daß es Licht derart reflektiert, daß mindestens eine der auf die lichtempfindliche Schicht einfallenden roten, grünen und blauen Komponenten des Lichts absorbiert wird, während die verbleibende oder die verbleibenden Komponenten reflektiert werden, um so die Empfindlichkeiten der drei verschiedenen lichtempfindlichen Materialien im wesentlichen auf das gleiche Maß zu bringen.

2. Eine lichtempfindliche Schicht nach Anspruch 1, wobei das schichtförmige Substrat so ausgelegt ist, daß es Licht reflektiert, indem es mindestens eine lichtreflektierende Fläche aufweist.

3. Eine lichtempfindliche Schicht nach Anspruch 2, wobei diese mindestens eine lichtreflektierende Fläche mittels einer Beschichtung aus einer lichtreflektierenden Substanz geschaffen wird.

4. Eine lichtempfindliche Schicht nach Anspruch 1, wobei das schichtförmige Substrat so ausgelegt ist, daß es Licht reflektiert, indem es aus einer lichtreflektierenden Substanz besteht.

5. Eine lichtempfindliche Schicht nach einem der vorgenannten Ansprüche, wobei das schichtförmige Substrat so Licht reflektiert, daß die rote Komponente des einfallenden Lichtes absorbiert wird, während die grünen und blauen Komponenten desselben reflektiert werden.

6. Eine lichtempfindliche Schicht nach einem der vorgenannten Ansprüche, wobei das in jeder Druckreißkapsel enthaltene chromogene Material eine Farbe hervorruft, die eine Komplementärfarbe des Lichtes ist, für welche das in den Druckreißkapseln enthaltene lichtempfindliche Material empfindlich ist.

7. Ein Bildaufzeichnungsverfahren, welches folgende Schritte umfaßt: Positionieren der lichtempfindlichen Schicht aus einem der vorgenannten Ansprüche auf einer Schichtbelichtungsauflage; Belichten der lichtempfindlichen Schicht mit dem Licht von oder durch ein gegebenes Bild einer Vorlage hindurch; Positionieren der lichtempfindlichen Schicht auf einer Bildempfängerschicht, welche mit Entwicklungsmaterialien beschichtet ist, so daß sich die Druckreißkapseln der lichtempfindlichen Schicht in Kontakt mit den Entwicklungsmaterialien der Bildempfängerschicht bringen lassen; und Aufeinanderpressen der beiden Schichten.

## Revendications

1. Feuille photosensible pour l'enregistrement d'une image en couleur, comprenant un substrat en forme de feuille apte à réfléchir la lumière, un revêtement sur ledit substrat en forme de feuille comprenant trois types de capsules pouvant être rompues à la pression, chaque type respectif de ces capsules pouvant être rompues à la pression contenant un type de matériau chromogène incolore et un type de matériau chromogène photosensible apte à durcir lorsqu'il est exposé à la lumière passant directement à travers les capsules pouvant être rompues à la pression ou à la lumière réfléchie par ledit substrat en forme de feuille à travers les capsules pouvant être rompues à la pression, dans les trois types de capsules pouvant être rompues à la pression les trois types respectifs de matériau photosensible étant sensibles respectivement, à la lumière rouge, verte et bleue,
caractérisé en ce que ledit substrat en forme de feuille est apte à réfléchir la lumière de telle sorte qu'au moins une composante des composantes rouge, verte et bleue de la lumière incidente sur la feuille photosensible est absorbée, tandis que l'autre composante ou chaque composante est réfléchie, de manière à compenser les sensibilités des trois types de matériaux photosensibles sensiblement au même degré.

2. Feuille photosensible selon la revendication 1, dans laquelle le substrat en forme de feuille est apte à réfléchir la lumière en ayant au moins une surface de réflexion de la lumière.

3. Feuille photosensible selon la revendication 2, dans laquelle ladite au moins une surface de réflexion de la lumière comporte un revêtement d'une substance de réflexion de la lumière.

4. Feuille photosensible selon la revendication 2, dans laquelle le substrat en forme de feuille est apte à réfléchir la lumière en étant réalisé en une substance de réflexion de la lumière.

5. Feuille photosensible selon l'une quelconque des revendications précédentes, dans laquelle le substrat en forme de feuille est apte à réfléchir la lumière de telle sorte que la composante rouge de la lumière incidente est absorbée, tandis que ses composantes verte et bleue sont réfléchies.

6. Feuille photosensible selon l'une quelconque des revendications précédentes, dans laquelle ladite substance chromogène contenue dans chaque capsule pouvant être rompue à la pression fait apparaître une couleur qui est une couleur complémentaire de la lumière à laquelle le matériau photosensible contenu dans la capsule est sensible.

7. Procédé de formation d'images comprenant les étapes consistant à placer la feuille photosensible de l'une quelconque des revendications précédentes sur une station d'exposition de la feuille; à exposer ladite feuille photosensible à la lumière en provenance d'une image donnée d'un manuscrit ou à travers celle-ci; à placer ladite feuille photosensible sur un feuille réceptrice d'image qui est revêtue de matériaux de développement de telle sorte que lesdites capsules pouvant être rompues à la pression de ladite feuille photosensible peuvent être mises en contact avec lesdits matériaux de développement de ladite feuille réceptrice d'image; et à appliquer une pression auxdites deux feuilles.
